# EUROPEAN PATENT SPECIFICATION

(11) **EP 4 359 905 B1**
(45) Date of publication and mention of the grant of the patent: **14.10.2026**
(21) Application number: 22829151.4
(22) Date of filing: 21.06.2022
(51) Int. Cl.: G06F 3/06, G11C 5/04

(54) **QUAD-CHANNEL MEMORY MODULE RELIABILITY**
QUAD-KANAL-SPEICHERMODULZUVERLÄSSIGKEIT
FIABILITÉ DE MODULE DE MÉMOIRE À QUATRE CANAUX

(30) Priority: 23.06.2021 US 202163214024 P; 05.10.2021 US 202163252237 P
(43) Date of publication of application: 01.05.2024
(73) Proprietor: Rambus Inc., San Jose, CA 95134 (US)
(72) Inventor: WOO, Steven, C., San Jose, CA 95134 (US); LEE, Dongyun, San Jose, CA 95134 (US)
(74) Representative: Eisenführ Speiser
(86) International application number: PCT/US2022/034338
(87) International publication number: WO 2022/271695

(56) References cited:
- WO-A1-2019/217118
- WO-A1-2020/176291
- US-A1- 2012 079 174
- US-A1- 2015 149 857
- US-A1- 2015 363 107
- US-A1- 2019 130 991
- US-A1- 2021 133 028
- US-B1- 8 947 931

## Description

### PRIOR ART

WO 2020/176291 A1: A DRAM includes at least four groups of memory cores and at least four memory access channel interfaces that, in a first mode, each respectively are to receive memory access commands, directed to a corresponding one of the groups of memory cores. One half of the memory access channel interfaces are to, in a second mode, each respectively receive memory access commands, directed to a corresponding two of four of the groups of memory cores. The memory access channel interfaces to have electrical connection conductors that lie on opposing sides of at least one line of reflectional symmetry from a second one-half of the one half of the at least four memory access channel interfaces.

WO 2019/217118 A1: Multiple independent point-to-point memory channels are operated, by at least one controller, in parallel to form a wider memory channel. The memory components on these point-to-point channels include the ability to connect to multiple (e.g., 2) instances of these independent memory channels. The controller operates multiple instances of the wider channels with the memory components configured in a clamshell mode. A single memory component is also operated in clamshell mode to provide error correction code information, independently of the other wider channels, to multiple instances of the wider memory channel.

### BRIEF DESCRIPTION OF THE DRAWINGS

Figure 1 illustrates a buffered memory module.
Figures 2-6 illustrate codeword configurations.
Figure 7 is a flowchart illustrating a method of operating a memory module.
Figure 8 is a flowchart illustrating a method of operating a memory module with multiple error correction and detection schemes.
Figure 9 is a flowchart illustrating a method for reconfiguring the operation of a memory module after a failed device.
Figure 10 is a flowchart illustrating a method for reconfiguring the operation of a memory module after a failed data signal.
Figure 11 is a flowchart illustrating a method for reconfiguring the operation of a memory module after a failed memory channel.
Figure 12 is a block diagram of a processing system.

### DETAILED DESCRIPTION OF THE EMBODIMENTS

The invention is set out in the appended set of claims.

A four-channel memory module includes four independent twenty (20) data bit memory channels and dual channel memory devices. The channels of the dual channel memory are accessed independently. Thus, the four channels for accessing the memory module each access one channel of a first set and a second set of dual channel memory devices on the module. Error detection and correction codeword configurations and schemes can implement chipkill, Single symbol data correct/double symbol data detect (SSDC/DSDD). Single symbol data correct with fewer memory devices may also be implemented. Error detection and correction codeword configurations and schemes may be switched in response to detecting a failed device, signal line, or memory channel.

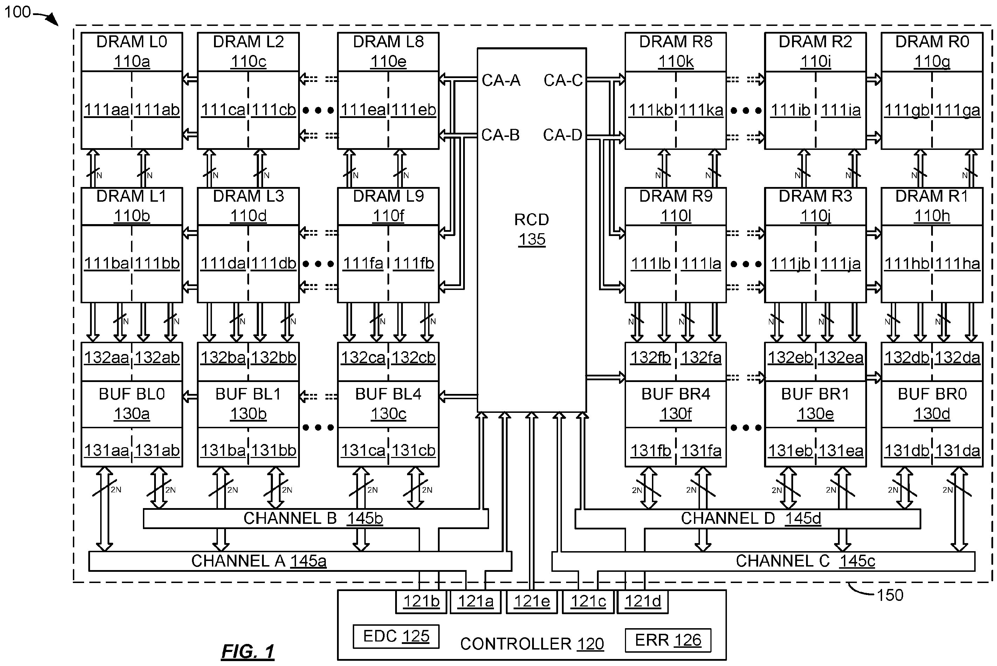

Figures 1 illustrates a buffered memory module. In Figure 1, memory system 100 comprises module 150 and controller 120. Controller 120 includes memory channel interfaces 121a-121d, common signal interface 121e, error detection and correction (EDC) circuitry 125, and persistent error detection circuitry 126. Memory channel interfaces 121a-121d are operatively coupled to channel A-D interfaces 145a-145d, respectively, of module 150.
Common signal interface 121e is operatively coupled to registering clock driver (RCD) 135 of module 150.

In Figure 1, module 150 comprises left side dual channel DRAM devices 110a-110f (representing ten DRAM devices L0-L9), right side dual channel DRAM devices 110g-110l (representing ten DRAM devices R0-R9), left side dual channel buffer devices 130a-130c (representing five buffer devices BL0-BL4), right side dual channel buffer devices 130d-130f (representing five buffer devices BR0-BR4), registering clock driver (RCD) 135, channel A interface 145a, channel B interface 145b, channel C interface 145c, and channel D interface 145d. RCD 135 receives certain signals (e.g., clock, chip select) that are common to the channel A-D interfaces 145a-145d. Dual channel DRAM devices 110a-110l may also be referred to as dual x2 DRAM devices.

Each dual channel DRAM device 110a-110l includes two nonoverlapping set of memory arrays that are respectively accessed via two channel interfaces 111aa-111lb that operate independently of each other. In other words, each DRAM device 110a-110l device operates the command, address, and data transfer functions of their respective channel interfaces 111aa-111lb independently of the other channel interfaces 111aa-111lb on the same DRAM device 110a-110l. Thus, for example, channel A interface 111aa of DRAM L0 110a accesses a first set of memory arrays in DRAM L0 110a and channel B interface 111ab of DRAM L0 110a accesses a second set of memory arrays in DRAM L0 110a, where the first set of memory arrays and the second set of memory array do not have any common memory array (i.e., are nonoverlapping sets).

At least the CA signals of channel A interface 145a are operatively coupled to RCD 135. RCD 135 operatively couples the CA signals of channel A interface 145a to the channel A interfaces 111aa-111fa of the left side DRAM devices 110a-110f. Similarly, at least the CA signals of channel B interface 145b are operatively coupled to RCD 135. RCD 135 operatively couples the CA signals of channel B interface 145b to the channel B interfaces 111ab-111fb of the left side DRAM devices 110a-110f.

At least the CA signals of channel C interface 145c are operatively coupled to RCD 135. RCD 135 operatively couples the CA signals of channel C interface 145c to the channel C interfaces 111ga-111la of the right side DRAM devices 110g-110l. Similarly, at least the CA signals of channel D interface 145d are operatively coupled to RCD 135. RCD 135 operatively couples the CA signals of channel D interface 145d to the channel D interfaces 111gb-111lb of the right side DRAM devices 110g-110l.

The channel A interface 111aa of DRAM device 110a is operatively coupled to communicate N bits of data with the device side channel A interface 132aa of data buffer device 130a. In an embodiment, N=2. The channel B interface 111ab of DRAM device 110a is operatively coupled to communicate N bits of data with the device side channel B interface 132ab of data buffer device 130a. The channel A interface 111ba of DRAM device 110b is operatively coupled to communicate N bits of data with the device side channel A interface 132aa of data buffer device 130a; the channel B interface 111bb of DRAM device 110b is operatively coupled to communicate N bits of data with the device side channel B interface 132ab of data buffer device 130a; the channel A interface 111ca of DRAM device 110c is operatively coupled to communicate N bits of data with the device side channel A interface 132ba of data buffer device 130b; the channel B interface 111cb of DRAM device 110c is operatively coupled to communicate N bits of data with the device side channel B interface 132bb of data buffer device 130a, and so on with a like pattern of connection for all of the DRAM devices 110a-110l and data buffer devices 130a-130f on module 150 (which, for the sake of brevity will not be detailed herein).

Controller side channel A interface 131aa is operatively coupled to channel A interface 145a. Controller side channel A interface 131aa communicates 2*N bits with channel A interface 145a. The 2*N bits comprise N bits communicated with DRAM device 110a and N bits communicated with DRAM device 110b for a total of 2*N number of bits. Similarly, controller side channel B interface 131ab is operatively coupled to channel B interface 145b. Likewise, the controller side channel A interfaces 131ba-131ca of data buffer devices 130b-130c are operatively coupled to channel A interface 145a; the controller side channel B interfaces 131bb-131cb of data buffer devices 130b-130c are operatively coupled to channel B interface 145b; the controller side channel C interfaces 131da-131fa of data buffer devices 130d-130f are operatively coupled to channel C interface 145c; and, the controller side channel D interfaces 131db-131fb of data buffer devices 130d-130f are operatively coupled to channel D interface 145d. Accordingly, each memory channel A-D 145a-145d therefore communicates with five (5) data buffer devices (left side data buffers 130a-130c or right side data buffers 130d-130f) each communicating using 2*N number of data signals resulting in twenty (20) data (DQ) signals per memory channel A-D 145a-145d when N=2.

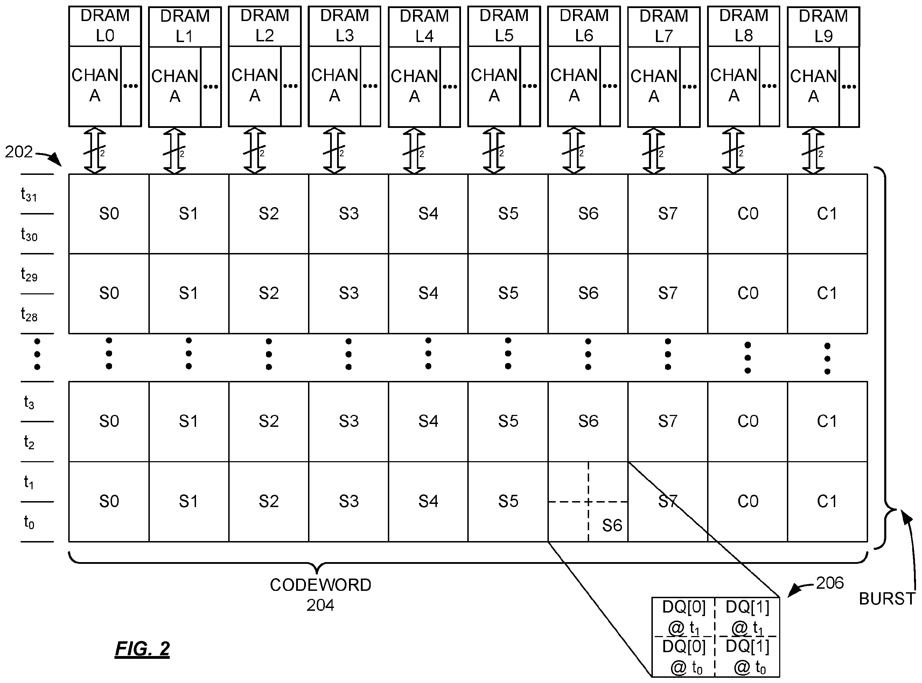

Figure 2 illustrates a first codeword configuration for reliability. In Figure 2, a burst 202 from a memory module (e.g., memory module 150) includes thirty-two (32) timeslots labeled t₀ through t₃₁. A channel (e.g., channel A) of each DRAM device (e.g., DRAM devices L0-L9 110a-110f) communicates two (2) bits (i.e., N=2) per burst 202 timeslot via data buffer devices (e.g., data buffer devices BL0-BL4 130a-130c). Each codeword 204 of burst 202 is composed of eight (8) data symbols S0-S7 and two check symbols C0-C1. Each symbol S0-S7, C0-C1 of codeword 204 is composed of four (4) bits communicated with a single DRAM device L0-L9 over two burst 202 timeslots. See, for example, symbol S6 206 called out in detail in Figure 2. Symbol S6 206 is composed of DQ[0] and DQ[1] communicated with DRAM L6 in timeslot t₀ and DQ[0] and DQ[1] communicated with DRAM L6 in timeslot t₁ thereby forming a four bit symbol communicated over two timeslots (t₀ and t₁). In an embodiment, the two timeslots are consecutive as illustrated in Figure 2. In other embodiments, the two timeslots may be nonconsecutive.

It should be understood that each codeword 204 is composed of forty (40) bits organized as ten total 4-bit symbols. The ten total symbols are composed of eight data symbols and two check symbols. Thus, codeword 204 may be generated, checked, and corrected (e.g., by EDC circuitry 125 of controller 120) using a Reed-Solomon (RS) error detection and correction scheme of RS(10,8). Using results from EDC circuitry 125, persistent error circuitry 126 may determine whether errors in codewords 204 are persistent. Also, because each symbol S0-S7, C0-C1 is communicated to/from a single DRAM L0-L9, the RS(10,8) scheme provides chipkill capability wherein the failure of an entire DRAM device L0-L9 is a correctible error.

When chipkill capability is used across two channels (e.g., channel A 145a and channel B 145b) that communicate with both channels (e.g., 111aa-111fa and 111ab-111fb) of a set of dual channel DRAMs (e.g., DRAM devices L0-L9 110a-110f) the presence of failures in a same DRAM (e.g., DRAM device L3 110d) across the two channels of that DRAM (e.g., 111da and 111db) indicate that this DRAM has failed. Thus, symbol errors on one of the two channels (e.g., channel A 145a) may indicate a need to 'kill' a failing/failed DRAM on the other channel (e.g., channel B 145b). In an embodiment, symbol errors on one of the two channels (e.g., channel A 145a) are used to initiate an error checking process (e.g., scrub operation) on the other channel (e.g., channel B 145b) before an error condition (e.g., chip failure) is detected on the other channel. In an embodiment, symbol errors on only one of the two channels (e.g., channel A 145a) may indicate a need to 'kill' a failing/failed channel (e.g., channel A 145a) while not altering the operation of the other channel (e.g., channel B 145b). Thus, the non-failing channel (e.g., channel B 145b) may operate using a different error correction and detection scheme than is used by the failing/failed channel (e.g., channel A 145a).

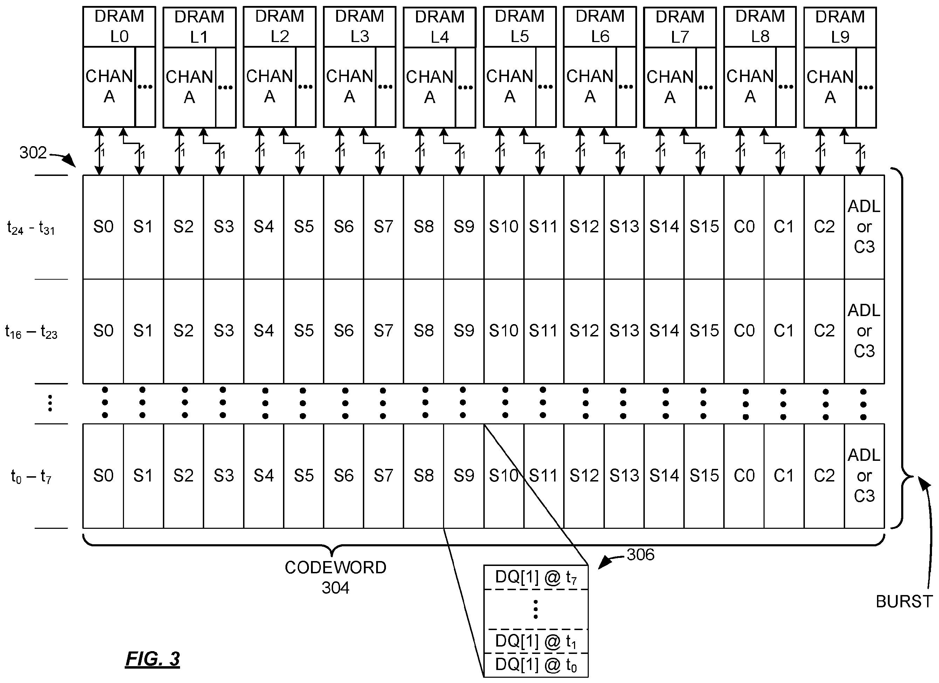

Figure 3 illustrates a second codeword configuration for reliability. In Figure 3, a burst 302 from a memory module (e.g., memory module 150) includes thirty-two (32) timeslots labeled t₀ through t₃₁. A channel (e.g., channel A) of each DRAM device (e.g., DRAM devices L0-L9 110a-110f) communicates two (2) bits (i.e., N=2) per burst 302 timeslot via data buffer devices (e.g., data buffer devices BL0-BL4 130a-130c). Each codeword 304 of burst 302 is composed of sixteen (16) data symbols S0-S15, three (3) check symbols C0-C2, and one additional symbol that may be a check symbol C3 or used to carry additional data (ADL). For the purposes of simplicity, this additional symbol will be referred to hereinafter as check symbol C3. Each symbol S0-S15, C0-C3 of codeword 304 is composed of eight (8) bits communicated with a single DRAM device L0-L9 over eight (8) burst 302 timeslots. See, for example, symbol S9 306 called out in detail in Figure 3. Symbol S9 306 is composed of DQ[1] communicated with DRAM L4 in timeslot t₀, DQ[1] communicated with DRAM L4 in timeslot t₁, DQ[1] communicated with DRAM L4 in timeslot t₂, and so on through timeslot t₇ -- thereby forming an eight bit symbol communicated over eight timeslots (t₀ through t₇). In an embodiment, the eight timeslots are consecutive as illustrated in Figure 3. In other embodiments, the eight timeslots may be nonconsecutive.

It should be understood that each codeword 304 is composed of 160 bits organized as twenty total 8-bit symbols. The twenty total symbols are composed of sixteen data symbols and either three or four check symbols. Thus, codeword 304 may be generated, checked, and corrected (e.g., by EDC circuitry 125 of controller 120) using either a RS(20,16) or RS(20,17) error detection and correction scheme. Using results from EDC circuitry 125, persistent error circuitry 126 may determine whether errors in codewords 304 are persistent. The RS(20,16) and RS(20,17) schemes provide single symbol data correct and double symbol data detect (SSDC/DSDD) capability.

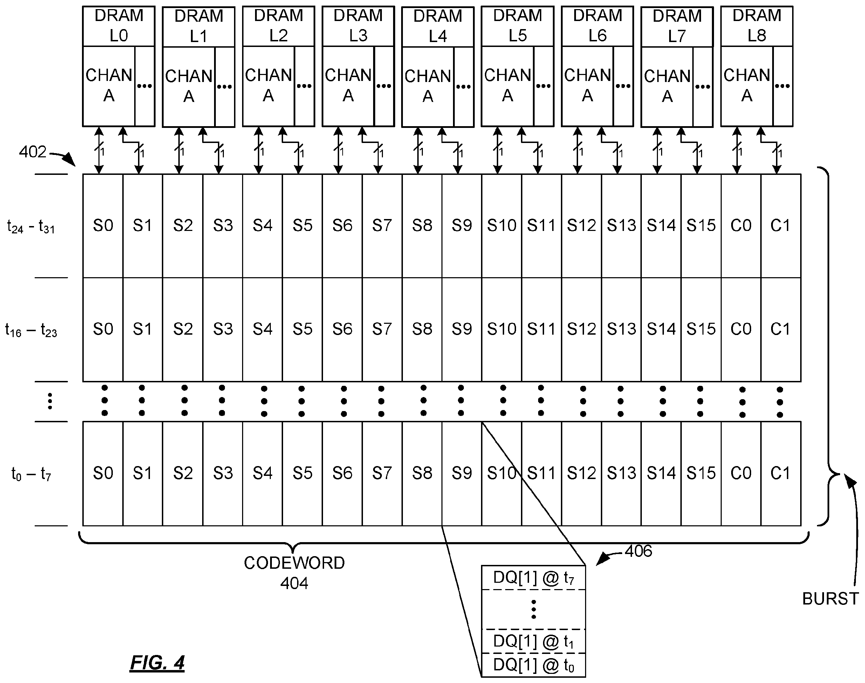

Figure 4 illustrates a third codeword configuration for reliability. In Figure 4, a burst 402 from a memory module includes thirty-two (32) timeslots labeled t₀ through t₃₁. In Figure 4, the channel includes only 18 DQ signals and therefore only requires communication with nine (9) DRAM devices L0-L8. A channel (e.g., channel A) of each DRAM device (e.g., DRAM devices L0-L8) communicates two (2) bits (i.e., N=2) per burst 402 timeslot via data buffer devices (e.g., data buffers BL0-BL4). Each codeword 404 of burst 402 is composed of sixteen (16) data symbols S0-S15, and two (2) check symbols C0-C1. Each symbol S0-S15, C0-C1 of codeword 404 is composed of eight (8) bits communicated with a single DRAM device L0-L8 over eight (8) burst 402 timeslots. See, for example, symbol S9 406 called out in detail in Figure 4. Symbol S9 406 is composed of DQ[1] communicated with DRAM L4 in timeslot t₀, DQ[1] communicated with DRAM L4 in timeslot t₁, DQ[1] communicated with DRAM L4 in timeslot t₂, and so on through timeslot t₇ -- thereby forming an eight bit symbol communicated over eight timeslots (t₀ through t₇). In an embodiment, the eight timeslots are consecutive as illustrated in Figure 4. In other embodiments, the eight timeslots may be nonconsecutive.

It should be understood that each codeword 404 is composed of 144 bits organized as eighteen (18) total 8-bit symbols. The eighteen total symbols are composed of sixteen data symbols and two check symbols. Thus, codeword 404 may be generated, checked, and corrected (e.g., by EDC circuitry 125 of controller 120) using a RS(18,16) error detection and correction scheme. Using results from EDC circuitry 125, persistent error detection circuitry 126 may determine whether errors in codewords 404 are persistent. The RS(18,16) scheme provides single symbol data correct (SSDC) capability.

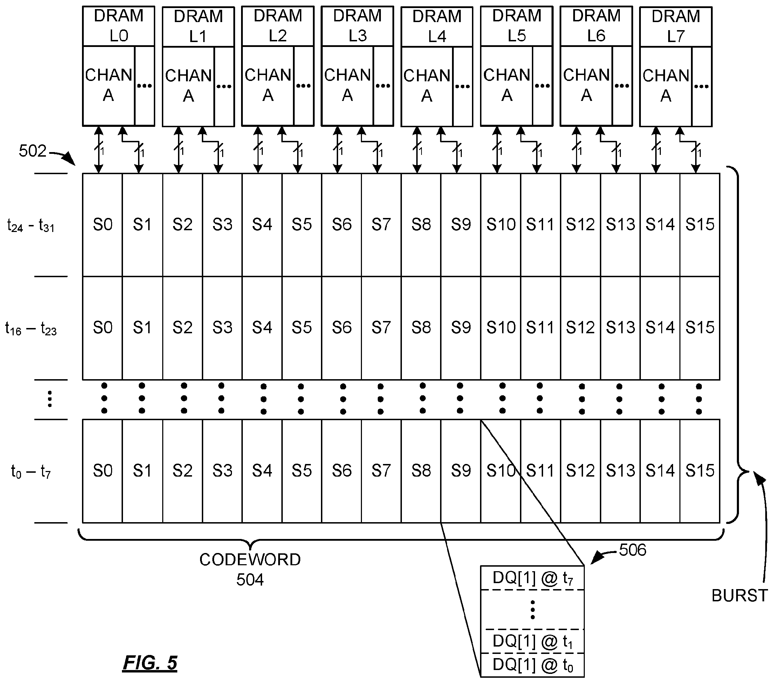

Figure 5 illustrates a fourth codeword configuration without redundant information for reliability. In Figure 5, a burst 502 from a memory module includes thirty-two (32) timeslots labeled t₀ through t₃₁. In Figure 5, the channel includes only sixteen (16) DQ signals and therefore only requires communication with eight (8) DRAM devices L0-L7. A channel (e.g., channel A) of each DRAM device (e.g., DRAM devices L0-L7) communicates two (2) bits (i.e., N=2) per burst 502 timeslot via four data buffer devices (e.g., data buffers BL0-BL3). Each codeword 504 of burst 502 is composed of sixteen (16) data symbols S0-S15. Each symbol S0-S15 of codeword 504 is composed of eight (8) bits communicated with a single DRAM device L0-L8 over eight (8) burst 502 timeslots. See, for example, symbol S9 506 called out in detail in Figure 5. Symbol S9 506 is composed of DQ[1] communicated with DRAM L4 in timeslot t₀, DQ[1] communicated with DRAM L4 in timeslot t₁, DQ[1] communicated with DRAM L4 in timeslot t₂, and so on through timeslot t₇ -- thereby forming an eight bit symbol communicated over eight timeslots (t₀ through t₇). In an embodiment, the eight timeslots are consecutive as illustrated in Figure 5. In other embodiments, the eight timeslots may be nonconsecutive.

It should be understood that each codeword 504 is composed of 128 bits organized as sixteen (16) total 8-bit symbols that does not include any check symbols. Thus, codeword 504 may not be generated, checked, and corrected using an error detection and correction scheme.

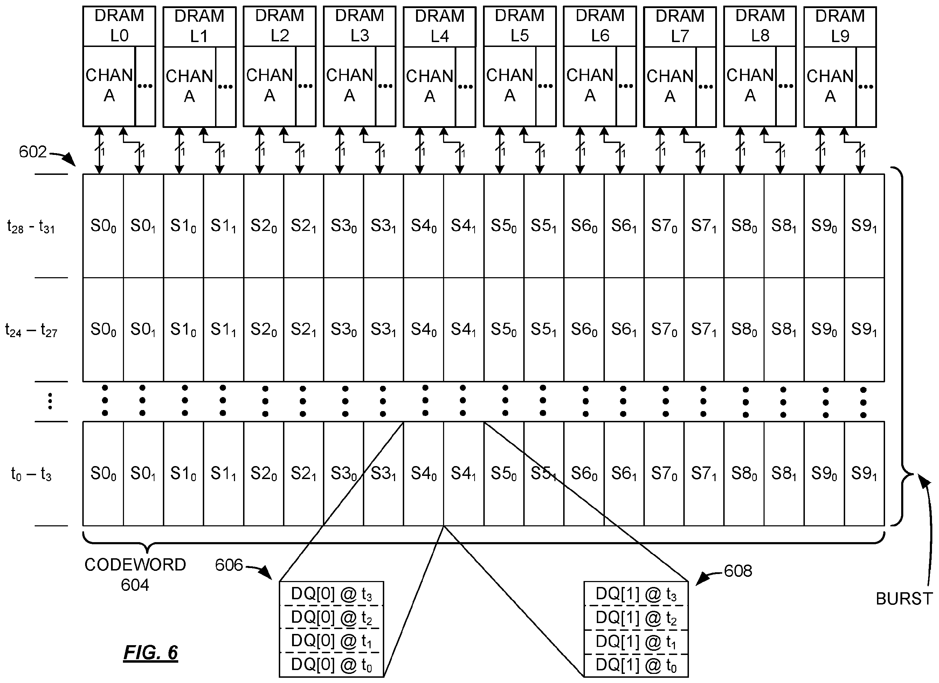

Figure 6 illustrates a fifth codeword configuration for reliability. In Figure 6, a burst 602 from a memory module (e.g., memory module 150) includes thirty-two (32) timeslots labeled t₀ through t₃₁. A channel (e.g., channel A) of each DRAM device (e.g., DRAM devices L0-L9 110a-110f) communicates two (2) bits (i.e., N=2) per burst 602 timeslot via data buffer devices (e.g., data buffer devices BL0-BL4 130a-130c). Each bit communicated per timeslot by a given DRAM device L0-L9 110a-110f is assigned to a different symbol of codeword 304. Each of the different symbols communicated with a given DRAM device L0-L9 is assigned to a different encoding group.

Each codeword 604 of burst 602 is composed of twenty (20) symbols divided into two ten symbol groups S0₀-S9₀ and S0₁-S9₁. Each symbol S0₀-S9₀, S0₁-S9₁ of codeword 604 is composed of four (4) bits communicated with a single DQ signal of a single DRAM device L0-L9 over four (4) burst 602 timeslots. See, for example, symbols S4₀ 606 and S4₁ called out in detail in Figure 6. Symbol S4₀ 606 is composed of DQ[0] communicated with DRAM L4 in timeslot t₀, DQ[0] communicated with DRAM L4 in timeslot t₁, DQ[0] communicated with DRAM L4 in timeslot t₂, and DQ[0] communicated with DRAM L4 in timeslot t₃ -- thereby forming a four bit symbol communicated over four timeslots (t₀ through t₃). Likewise, symbol S4₁ 608 is composed of DQ[1] communicated with DRAM L4 in timeslot t₀, DQ[1] communicated with DRAM L4 in timeslot t₁, DQ[1] communicated with DRAM L4 in timeslot t₂, and DQ[1] communicated with DRAM L4 in timeslot t₃ -- thereby forming a four bit symbol communicated over four timeslots (t₀ through t₃). In an embodiment, the four timeslots are consecutive as illustrated in Figure 6. In other embodiments, the four timeslots may be nonconsecutive.

It should be understood that each codeword 604 is composed of 80 bits organized as twenty total 4-bit symbols. The twenty total symbols are composed of ten data symbols assigned to a first encoding group (symbols S0₀-S9₀) and ten data symbols assigned to a second encoding group (symbols S0₁-S9₁). Thus, each encoding group S0₀-S9₀ and S0₁-S9₁ of codeword 604 may be generated, checked, and corrected (e.g., by EDC circuitry 125 of controller 120) using independent RS(10,8) error detection and correction schemes. Using results from EDC circuitry 125, persistent error detection circuitry 126 may determine whether errors in codewords 604 are persistent. The RS(10,8) scheme provides single symbol data correct capability. Thus, because each of the two bits communicated with a DRAM device L0-L9 is assigned to a different symbol, and the two different symbols are assigned to different encoding groups, the dual RS(10,8) group scheme of codeword 604 provides one DQ or a quarter device correction capability.

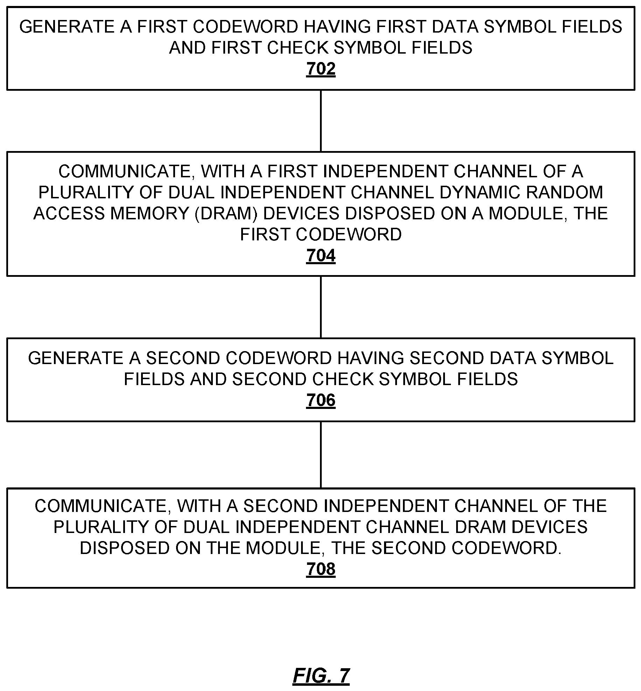

Figure 7 is a flowchart illustrating a method of operating a memory module. One or more of the steps illustrated in Figure 7 may be performed by, for example, memory system 100, and/or its components. A first codeword having first data symbols fields and first check symbol fields is generated (702). For example, EDC circuitry 125 of controller 120 may generate codeword 204 having data symbol fields S0-S7 and check symbol fields C0-C1.

The first codeword is communicated with a first independent channel of a plurality of dual independent channel dynamic random access memory (DRAM) devices disposed on a module (704). For example, controller 120 may communicate, via memory channel A interface 121a, memory channel A 145a of module 150, and data buffer devices 130a-130c a codeword 204 with the memory channel A interfaces 111aa-111fa of DRAM devices L0-L9 110a-110f.

A second codeword having second data symbols fields and second check symbol fields is generated (706). For example, EDC circuitry 125 of controller 120 may generate codeword 304 having data symbol fields S0-S15 and check symbol fields C0-C3. The second codeword is communicated with a second independent channel of a plurality of dual independent channel DRAM devices disposed on the module (708). For example, controller 120 may communicate, via memory channel B interface 121b, memory channel B 145b of module 150, and data buffer devices 130a-130c a codeword 304 with the memory channel B interfaces 111ab-111fb of DRAM devices L0-L9 110a-110f.

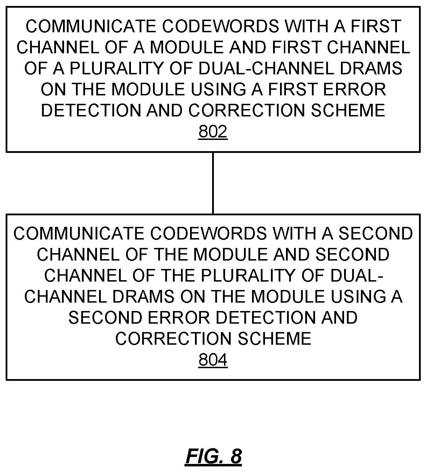

Figure 8 is a flowchart illustrating a method of operating a memory module with multiple error correction and detection schemes. One or more of the steps illustrated in Figure 8 may be performed by, for example, memory system 100, and/or its components. Codewords are communicated with a first channel of a module and first channel of a plurality of dual-channel DRAMs on the module using a first error detection and correction scheme (802). For example, controller 120 may communicate, via memory channel A interface 121a, memory channel A 145a of module 150, and data buffers devices 130a-130c a codeword 204 with the memory channel A interfaces 111aa-111fa of DRAM devices L0-L9 110a-110f that is encoded with a RS(10,8) error detection and correction scheme.

Codewords are communicated with a second channel of a module and second channel of the plurality of dual-channel DRAMs on the module using a second error detection and correction scheme (804). For example, controller 120 may communicate, via memory channel B interface 121b, memory channel B 145b of module 150, and data buffer devices 130a-130c a codeword 304 with the memory channel B interfaces 111ab-111fb of DRAM devices L0-L9 110a-110f that is encoded with a RS(20,17) error detection and correction scheme.

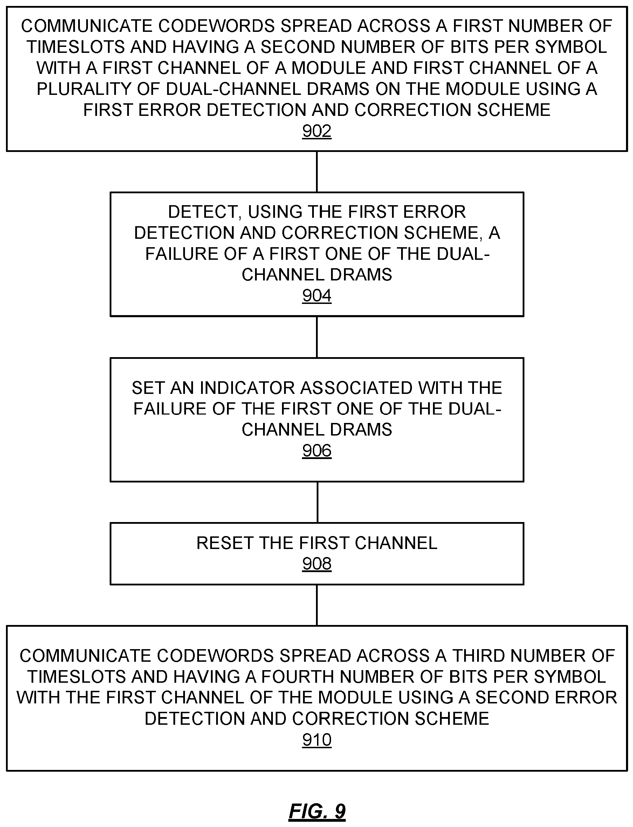

Figure 9 is a flowchart illustrating a method for reconfiguring the operation of a memory module after a failed device is identified. One or more of the steps illustrated in Figure 9 may be performed by, for example, memory system 100, and/or its components. Codewords spread across a first number of timeslots and having a second number of bits per symbol are communicated with a first channel of a module and first channel of a plurality of dual-channel DRAMs on the module using a first error detection and correction scheme (902). For example, controller 120 may communicate, via memory channel A interface 121a, memory channel A 145a of module 150, and data buffers devices 130a-130c codewords 204, which have a symbol size of four bits communicated over two timeslots and are encoded with a RS(10,8) error detection and correction scheme, with the memory channel A interfaces 111aa-111fa of DRAM devices L0-L9 110a-110f.

Using the first error detection and correction scheme, a failure of a first one of the dual-channel DRAMs is detected (904). For example, EDC circuitry 125 of controller 120 may, using the RS(10,8) EDC scheme, detect a failure of DRAM device L3 110d. Using results from EDC circuitry 125, persistent error detection circuitry 126 may determine that DRAM device L3 110d has a persistent failure. An indicator associated with the failure of the first one of the dual-channel DRAMs is set (906). For example, controller 120 may, in response to detecting the failure of DRAM device L3 110d, set an internal bit or register with an indicator that DRAM device L3 110d has failed. Controller 120 may also transmit an indicator that DRAM device L3 110d has failed to a host and/or host operating system.

The first channel is reset (908). For example, controller 120 may, in response to detecting the failure of DRAM device L3 110d, stop using DRAM L3 110d. Codewords spread across a third number of timeslots and having a fourth number of bits per symbol are communicated with the first channel of the module using a second error detection and correction scheme (910). For example, controller 120 may communicate, via memory channel A interface 121a, memory channel A 145a of module 150, and data buffer devices 130a-130c codewords 404, which have a symbol size of eight bits communicated over eight timeslots and are encoded with a RS(18,16) error detection and correction scheme, with the memory channel A interfaces 111aa-111fa of DRAM devices L0-L2, L4-L9 110a-110f.

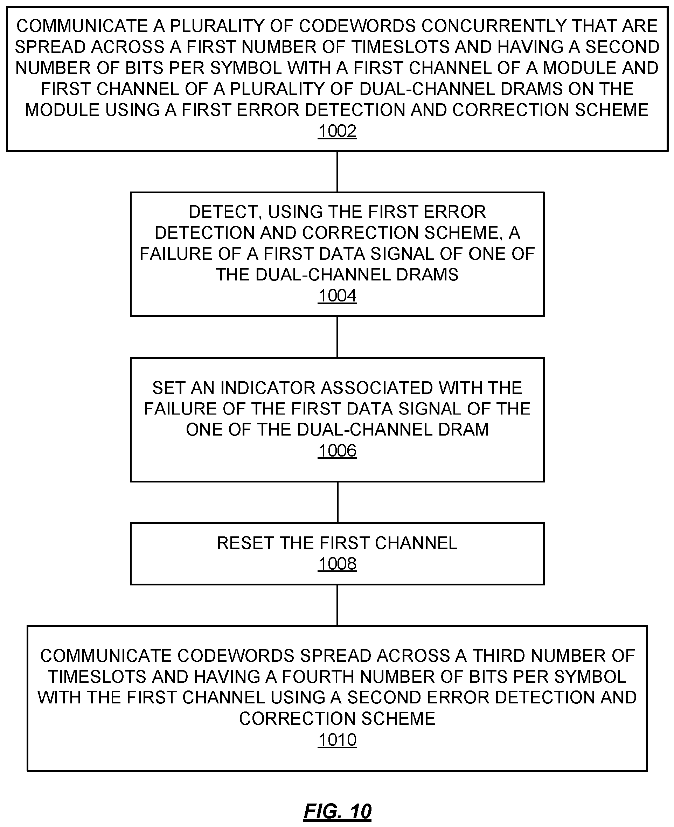

Figure 10 is a flowchart illustrating a method for reconfiguring the operation of a memory module after a failed data signal. One or more of the steps illustrated in Figure 10 may be performed by, for example, memory system 100, and/or its components. A plurality of codewords spread across a first number of timeslots and having a second number of bits per symbol are communicated concurrently with a first channel of a module and first channel of a plurality of dual-channel DRAMs on the module using a first error detection and correction scheme (1002). For example, controller 120 may communicate, via memory channel A interface 121a, memory channel A 145a of module 150, and data buffer devices 130a-130c codewords 604, which are divided into two encoding groups, have a symbol size of four bits communicated over four timeslots and are encoded with two independent RS(10,8) error detection and correction schemes, with the memory channel A interfaces 111aa-111fa of DRAM devices L0-L9 110a-110f.

Using the first error detection and correction scheme, a failure of a first data signal of a one of the dual-channel DRAMs is detected (1004). For example, EDC circuitry 125 of controller 120 may, using the RS(10,8) EDC scheme, detect a failure of a data (DQ) signal of DRAM device L3 110d. Using results from EDC circuitry 125, persistent error detection circuitry 126 may determine that the data (DQ) signal of DRAM device L3 110d has a persistent failure. An indicator associated with the failure of the first data signal of the one of the dual-channel DRAMs is set (1006). For example, controller 120 may, in response to detecting the failure of the DQ signal of DRAM device L3 110d, set an internal bit or register with an indicator that the DQ signal of DRAM device L3 110d has failed. Controller 120 may also transmit an indicator that the DQ signal of DRAM device L3 110d has failed to a host and/or host operating system.

The first channel is reset (1008). For example, in response to detecting the failure of the DQ signal of DRAM device L3 110d, controller 120 may, stop using DRAM device L3 110d. Codewords spread across a third number of timeslots and having a fourth number of bits per symbol are communicated with the first channel of the module using a second error detection and correction scheme (1010). For example, in response to detecting the failure of the DQ signal of DRAM device L3 110d, controller 120 may communicate, via memory channel A interface 121a, memory channel A 145a of module 150, and data buffer devices 130a-130c codewords 404, which have a symbol size of eight bits communicated over eight timeslots and are encoded with a RS(18,16) error detection and correction scheme, with the memory channel A interfaces 111aa-111fa of DRAM devices L0-L2, L4-L9 110a-110f.

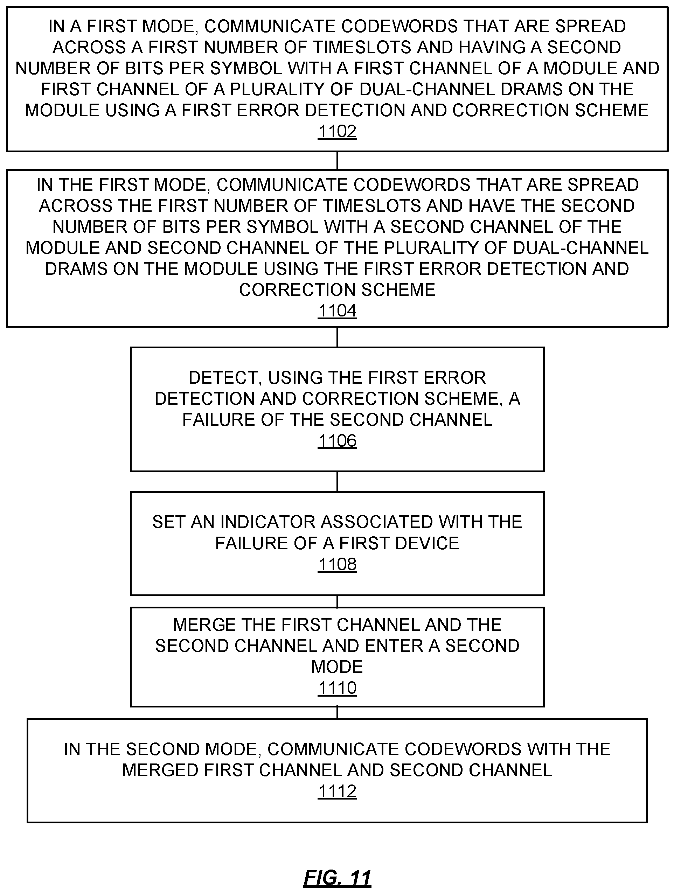

Figure 11 is a flowchart illustrating a method for reconfiguring the operation of a memory module after a failed memory channel. One or more of the steps illustrated in Figure 11 may be performed by, for example, memory system 100, and/or its components. In a first mode, codewords spread across a first number of timeslots and having a second number of bits per symbol are communicated with a first channel of a module and first channel of a plurality of dual-channel DRAMs on the module using a first error detection and correction scheme (1102). For example, controller 120 may communicate, via memory channel A interface 121a, memory channel A 145a of module 150, and data buffer devices 130a-130c codewords 204, which have a symbol size of four bits communicated over two timeslots and are encoded with a RS(10,8) error detection and correction scheme, with the memory channel A interfaces 111aa-111fa of DRAM devices L0-L9 110a-110f.

In the first mode, codewords spread across the first number of timeslots and having the second number of bits per symbol are communicated with a second channel of a module and second channel of the plurality of dual-channel DRAMs on the module using the first error detection and correction scheme (1104). For example, controller 120 may communicate, via memory channel B interface 121b, memory channel B 145b of module 150, and data buffer devices 130a-130c codewords 204, which have a symbol size of four bits communicated over two timeslots and are encoded with the RS(10,8) error detection and correction scheme, with the memory channel B interfaces 111ab-111fb of DRAM devices L0-L9 110a-110f.

Using the first error detection and correction scheme, a failure of the second channel is detected (1106). For example, EDC circuitry 125 of controller 120 may, using the RS(10,8) EDC scheme, detect a failure of circuitry associated with the B channel of DRAM device L3 110d (e.g., memory channel B interface 111db, array accessed using memory channel B interface 111db, etc.). Using results from EDC circuitry 125, persistent error detection circuitry 126 may determine that the circuitry associated with the B channel of DRAM device L3 110d has a persistent failure. An indicator associated with the failure of a first device is set (1108). For example, controller 120 may, in response to detecting the failure of circuitry associated with the B channel of DRAM device L3 110d, set an internal bit or register with an indicator that circuitry associated with the B channel of DRAM device L3 110d has failed. Controller 120 may also transmit an indicator that circuitry associated with the B channel of DRAM device L3 110d has failed to a host and/or host operating system.

The first channel and the second channel are merged and a second mode is entered (1110). For example, controller 120 may enter a mode where the data symbols and check symbols for codewords are spread across both the memory channel A interface 121a and the memory channel B interface 121b. In the second mode, codewords are communicated with the merged first channel and second channel (1112). For example, controller 120 may communicate data with module 150 using an error detection and correction scheme that spreads the data symbols and check symbols for codewords are spread across both the memory channel A interface 121a and the memory channel B interface 121b. For example, when only nine (9) DRAM devices with x4 data signals are working correctly, a RS(18,16) scheme spread over the two channels A and B may be used. One symbol may be 4 bits with 2 bits of each DRAM spread over two bursts. One symbol is corrected, meaning "half" of the DRAM is corrected when the DRAM is configured internally to follow a "bounded fault" scheme.

The methods, systems and devices described above may be implemented in computer systems, or stored by computer systems. The methods described above may also be stored on a non-transitory computer readable medium. Devices, circuits, and systems described herein may be implemented using computer-aided design tools available in the art, and embodied by computer-readable files containing software descriptions of such circuits. This includes, but is not limited to one or more elements of memory system 100, its their components. These software descriptions may be: behavioral, register transfer, logic component, transistor, and layout geometry-level descriptions. Moreover, the software descriptions may be stored on storage media or communicated by carrier waves.

Data formats in which such descriptions may be implemented include, but are not limited to: formats supporting behavioral languages like C, formats supporting register transfer level (RTL) languages like Verilog and VHDL, formats supporting geometry description languages (such as GDSII, GDSIII, GDSIV, CIF, and MEBES), and other suitable formats and languages. Moreover, data transfers of such files on machine-readable media may be done electronically over the diverse media on the Internet or, for example, via email. Note that physical files may be implemented on machine-readable media such as: 4 mm magnetic tape, 8 mm magnetic tape, 3-1/2 inch floppy media, CDs, DVDs, and so on.

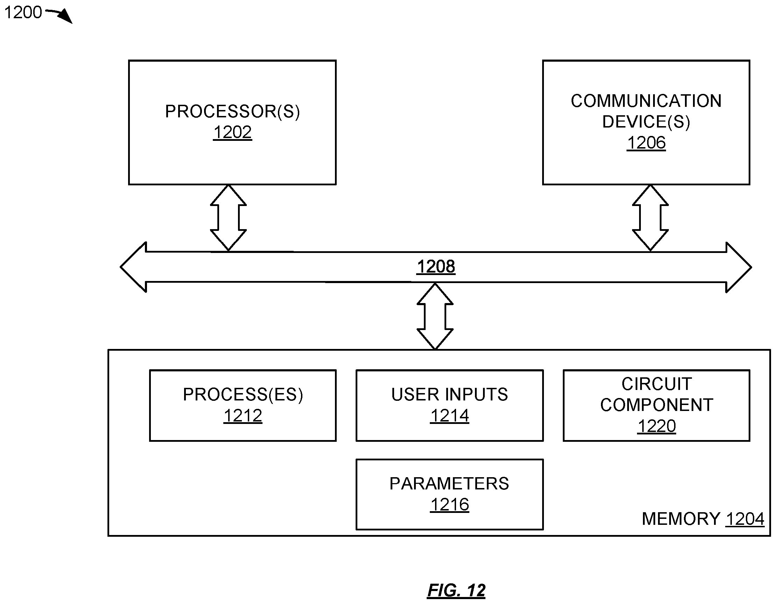

Figure 12 is a block diagram illustrating one embodiment of a processing system 1200 for including, processing, or generating, a representation of a circuit component 1220. Processing system 1200 includes one or more processors 1202, a memory 1204, and one or more communications devices 1206. Processors 1202, memory 1204, and communications devices 1206 communicate using any suitable type, number, and/or configuration of wired and/or wireless connections 1208.

Processors 1202 execute instructions of one or more processes 1212 stored in a memory 1204 to process and/or generate circuit component 1220 responsive to user inputs 1214 and parameters 1216. Processes 1212 may be any suitable electronic design automation (EDA) tool or portion thereof used to design, simulate, analyze, and/or verify electronic circuitry and/or generate photomasks for electronic circuitry. Representation 1220 includes data that describes all or portions of memory system 100, and its components, as shown in the Figures.

Representation 1220 may include one or more of behavioral, register transfer, logic component, transistor, and layout geometry-level descriptions. Moreover, representation 1220 may be stored on storage media or communicated by carrier waves.

Data formats in which representation 1220 may be implemented include, but are not limited to: formats supporting behavioral languages like C, formats supporting register transfer level (RTL) languages like Verilog and VHDL, formats supporting geometry description languages (such as GDSII, GDSIII, GDSIV, CIF, and MEBES), and other suitable formats and languages. Moreover, data transfers of such files on machine-readable media may be done electronically over the diverse media on the Internet or, for example, via email

User inputs 1214 may comprise input parameters from a keyboard, mouse, voice recognition interface, microphone and speakers, graphical display, touch screen, or other type of user interface device. This user interface may be distributed among multiple interface devices. Parameters 1216 may include specifications and/or characteristics that are input to help define representation 1220. For example, parameters 1216 may include information that defines device types (e.g., NFET, PFET, etc.), topology (e.g., block diagrams, circuit descriptions, schematics, etc.), and/or device descriptions (e.g., device properties, device dimensions, power supply voltages, simulation temperatures, simulation models, etc.).

Memory 1204 includes any suitable type, number, and/or configuration of non-transitory computer-readable storage media that stores processes 1212, user inputs 1214, parameters 1216, and circuit component 1220.

Communications devices 1206 include any suitable type, number, and/or configuration of wired and/or wireless devices that transmit information from processing system 1200 to another processing or storage system (not shown) and/or receive information from another processing or storage system (not shown). For example, communications devices 1206 may transmit circuit component 1220 to another system. Communications devices 1206 may receive processes 1212, user inputs 1214, parameters 1216, and/or circuit component 1220 and cause processes 1212, user inputs 1214, parameters 1216, and/or circuit component 1220 to be stored in memory 1204.

The foregoing description of the invention has been presented for purposes of illustration and description. It is not intended to be exhaustive or to limit the invention to the precise form disclosed, and other modifications and variations may be possible in light of the above teachings. The embodiment was chosen and described in order to best explain the principles of the invention and its practical application to thereby enable others skilled in the art to best utilize the invention in various embodiments and various modifications as are suited to the particular use contemplated. It is intended that the appended claims be construed to include other alternative embodiments of the invention except insofar as limited by the prior art.

## Claims

1. A controller (120), comprising:
four memory channel controller interfaces (121a-121d) to communicate with four memory channel module interfaces (145a-145d) on a memory module (150) comprising a substrate and dual x2 dynamic random access memory (DRAM) devices (110a-110h), the dual x2 DRAM devices (110a-110h) each having a respective first memory access interface (111aa-111ha) and a respective second memory access interface (111ab-111hb) that operate independently of each other to access one of two respective sets of memory cores that are nonoverlapping sets;
a first memory channel controller interface (121a) of the four memory channel controller interfaces (121a-121d) to communicate first data symbols and first check symbols, arranged into first codewords (204), with respective first memory access interfaces (111aa-111fa) of the dual x2 DRAM devices (110a-110f); and
a second memory channel controller interface (121b) of the four memory channel controller interfaces (121a-121d) to communicate second data symbols and second check symbols, arranged into second codewords (204), with respective second memory access interfaces (111ab-111fb) of the dual x2 DRAM devices (110a-110f),
coding of first data symbols and first check symbols according to a first error detection and correction scheme and coding of second data symbols and second check symbols according to a second error detection and correction scheme that is different than the first error detection and correction scheme.

2. The controller (120) of claim 1, comprising:
error detection and correction circuitry (125) to process the first codewords (204; 304; 404; 504) to determine whether there are errors in the first codewords (204; 304; 404; 504).

3. The controller of claim 2, comprising:
persistent error detection circuitry (125) to determine whether errors in the first codewords (204; 304; 404; 504) are persistent.

4. The controller of claim 3, wherein when the persistent error detection circuitry (125) determines errors in the first codewords (204; 304; 404; 504) are persistent, the controller communicates third data symbols and third check symbols, arranged into third codewords (204; 304; 404; 504), with the first memory access interfaces (111aa-111fa) and the second memory access interfaces (111ab-111fb) of the dual x2 DRAM devices (110a-110f), in particular wherein the third data symbols and third check symbols have more bits than the first data symbols and first check symbols.

## Patentansprüche

1. Steuereinheit (120), umfassend:
vier Speicherkanal-Steuerschnittstellen (121a-121d) zum Kommunizieren mit vier Speicherkanalmodulschnittstellen (145a-145d) auf einem Speichermodul (150), das ein Substrat und Dual-x2-DRAM-Vorrichtungen (110a-110h) umfasst, wobei jede der Dual-x2-DRAM-Vorrichtungen (110a-110h) eine jeweilige erste Speicherzugriffsschnittstelle (111aa-111ha) und eine jeweilige zweite Speicherzugriffsschnittstelle (111ab-111hb) aufweist, die unabhängig voneinander arbeiten, um auf einen von zwei jeweiligen Sätzen von Speicherkernen zuzugreifen, bei denen es sich um sich nicht überschneidende Sätze handelt;
eine erste Speicherkanal-Steuerschnittstelle (121a) der vier Speicherkanal-Steuerschnittstellen (121a-121d) zum Kommunizieren erster Datensymbole und erster Prüfsymbole, die in ersten Codewörtern (204) angeordnet sind, mit jeweiligen ersten Speicherzugriffsschnittstellen (111aa-111fa) der Dual-x2-DRAM-Vorrichtungen (110a-110f); und
eine zweite Speicherkanal-Steuerschnittstelle (121b) der vier Speicherkanal-Steuerschnittstellen (121a-121d) zum Kommunizieren zweiter Datensymbole und zweiter Prüfsymbole, die in zweiten Codewörtern (204) angeordnet sind, mit jeweiligen zweiten Speicherzugriffsschnittstellen (111 ab-111 fb) der Dual-x2-DRAM-Vorrichtungen (110a-110f), sowie
ein Codieren erster Datensymbole und erster Prüfsymbole gemäß einem ersten Fehlererkennungs- und -korrekturschema und Codieren zweiter Datensymbole und zweiter Prüfsymbole gemäß einem zweiten Fehlererkennungs- und -korrekturschema, das sich von dem ersten Fehlererkennungs- und -korrekturschema unterscheidet.

2. Steuereinheit (120) nach Anspruch 1, umfassend:
Fehlererkennungs- und -korrekturschaltung (125) zum Verarbeiten der ersten Codewörter (204; 304; 404; 504), um festzustellen, ob Fehler in den ersten Codewörtern (204; 304; 404; 504) vorliegen.

3. Steuereinheit nach Anspruch 2, umfassend:
eine Schaltung zum Erkennen persistenter Fehler (125), um festzustellen, ob Fehler in den ersten Codewörtern (204; 304; 404; 504) persistent sind.

4. Steuereinheit nach Anspruch 3, wobei, wenn die Schaltung zum Erkennen persistenter Fehler (125) feststellt, dass Fehler in den ersten Codewörtern (204; 304; 404; 504) persistent sind, die Steuereinheit dritte Datensymbole und dritte Prüfsymbole, die in dritten Codewörtern (204; 304; 404; 504) angeordnet sind, mit den ersten Speicherzugriffsschnittstellen (111 aa-111 fa) und den zweiten Speicherzugriffsschnittstellen (111ab-111fb) der Dual-x2-DRAM-Vorrichtungen (110a-110f) kommuniziert, wobei insbesondere die dritten Datensymbole und dritten Prüfsymbole mehr Bits aufweisen als die ersten Datensymbole und ersten Prüfsymbole.

## Revendications

1. Contrôleur (120), comprenant :
quatre interfaces de contrôleur de canal de mémoire (121a-121d) pour communiquer avec quatre interfaces de module de canal de mémoire (145a-145d) sur un module de mémoire (150) comprenant un substrat et des dispositifs de mémoire vive dynamique (DRAM) à double 2x (110a-110h), les dispositifs DRAM à double 2x (110a-110h) ayant chacun une première interface d'accès à la mémoire respective (111aa-111ha) et une deuxième interface d'accès à la mémoire respective (111ab-111hb) qui fonctionnent indépendamment l'une de l'autre pour accéder à l'un de deux ensembles respectifs de noyaux de mémoire qui sont des ensembles non chevauchants ;
une première interface de contrôleur de canal de mémoire (121a) des quatre interfaces de contrôleur de canal de mémoire (121a-121d) pour communiquer des premiers symboles de données et des premiers symboles de contrôle, agencés en premiers mots de code (204), avec des premières interfaces d'accès à la mémoire respectives (111aa-111fa) des dispositifs DRAM à double 2x (110a-110f) ; et
une deuxième interface de contrôleur de canal de mémoire (121b) des quatre interfaces de contrôleur de canal de mémoire (121a-121d) pour communiquer des deuxièmes symboles de données et des deuxièmes symboles de contrôle, agencés en deuxièmes mots de code (204), avec des deuxièmes interfaces d'accès à la mémoire respectives (111ab-111fb) des dispositifs DRAM à double 2x (110a-110f),
le codage de premiers symboles de données et de premiers symboles de contrôle conformément à un premier schéma de détection et de correction d'erreur et le codage de deuxièmes symboles de données et de deuxièmes symboles de contrôle conformément à un deuxième schéma de détection et de correction d'erreur qui est différent du premier schéma de détection et de correction d'erreur.

2. Contrôleur (120) selon la revendication 1, comprenant :
une circuiterie de détection et de correction d'erreur (125) pour traiter les premiers mots de code (204 ; 304 ; 404 ; 504) pour déterminer s'il y a des erreurs dans les premiers mots de code (204 ; 304 ; 404 ; 504).

3. Contrôleur selon la revendication 2, comprenant :
une circuiterie de détection d'erreur persistante (125) pour déterminer si des erreurs dans les premiers mots de code (204 ; 304 ; 404 ; 504) sont persistantes.

4. Contrôleur selon la revendication 3, dans lequel lorsque la circuiterie de détection d'erreur persistante (125) détermine que des erreurs dans les premiers mots de code (204 ; 304 ; 404 ; 504) sont persistantes, le contrôleur communique des troisièmes symboles de données et des troisièmes symboles de contrôle, agencés en troisièmes mots de code (204 ; 304 ; 404 ; 504), avec les premières interfaces d'accès à la mémoire (111aa-111fa) et les deuxièmes interfaces d'accès à la mémoire (111ab-111fb) des dispositifs DRAM à double 2x (110a-110f), en particulier dans lequel les troisièmes symboles de données et les troisièmes symboles de contrôle ont plus de bits que les premiers symboles de données et les premiers symboles de contrôle.
